# EUROPEAN PATENT SPECIFICATION

(11) **EP 0 452 027 B1**
(45) Date of publication and mention of the grant of the patent: **02.11.1995**
(21) Application number: 91302911.2
(22) Date of filing: 03.04.1991
(51) Int. Cl.: G02F 1/1335, G03F 1/00, G03F 7/12

(54) **Correction of defects in colour filters**
Fehler-Korrektur für Farbfilter
Correction de défauts pour filtres colorés

(30) Priority: 13.04.1990 JP 96649/90
(43) Date of publication of application: 16.10.1991
(73) Proprietor: INTERNATIONAL BUSINESS MACHINES CORPORATION, Armonk, NY 10504 (US)
(72) Inventor: Fukunaga, Tetsuya, Sagamihara-shi, Kanagawa-ken (JP); Ikeda, Ayumi, Yokohama-shi, Kanagawa-ken (JP); Ueki, Toshihiro, Machida-shi, Tokyo-to (JP)
(74) Representative: Burt, Roger James, Dr.

(56) References cited:
- EP-A- 0 320 264
- FR-A- 2 586 488
- US-A- 4 948 706
- PATENT ABSTRACTS OF JAPAN vol. 12, no. 383 (P-770) 13 October 1988 ; & JP-A-63 128 302
- IBM TECHNICAL DISCLOSURE BULLETIN, vol. 15, no. 4, September 1972, NEW YORK US, page 1345; N. CHAND : "Method for repairing hard mask"

## Description

This invention relates to the correction of defects in colour filters, and particularly to a method of correcting pixel defects in colour filters that are suitable for use in a liquid crystal display device.

There exist several methods of manufacturing colour filters for use in colour liquid crystal display devices, for example the dyeing method, the electrodeposition method, the printing method, and the dispersion method. The dyeing method dyes a synthetic high polymer or a natural protein such as gelatin, glue, or casein to obtain a colour filter. The colour filter made by this method, however, has problems regarding storage stability against moisture, light resistance, and heat resistance; in larger pictures it is difficult to obtain uniform control of dyeing and adhesive characteristics, leading to problems in controlling both film-thickness and evenness of colour.

In the electrodeposition method, a transparent electrode, formed in advance into a specified pattern, has a voltage applied to it whilst in a bath containing an ionized high polymer. This polymer contains a pigment, dissolved or dispersed in a solvent, to colour the pixels. The electrodeposition method requires a photolithography process, including transparent electrode coating to form colour filters, and an etching process performed on the transparent electrode for display. With colour filters manufactured by this method, any short-circuit results in a line defect, causing a drop in yield. Thus, there are problems in that it is difficult to apply, and it is difficult to control the transparent electrode film quality.

The printing method utilizes such methods as dry offset printing and intaglio offset printing. However, its use is limited because filtering of the ink is difficult due to its high viscosity, because defects are apt to occur due to dust, foreign matter, and the ink binder gel, and because there are problems of insufficient positional accuracy, line width accuracy, and surface smoothness. For these reasons it is difficult to use for high resolution colour displays with large screens.

The dispersion method forms color filters with pigment dispersed in a negative type photosensitive resin. The dispersion method forms coloured pixels by a coating, exposure, and development process. The filter obtained by this method is stable against stresses such as light and heat since pigments are used. Further, position accuracy is adequate because patterning is done through use of photolithography. Thus it is suitable for high resolution colour displays with a large screen.

Published Unexamined Patent Application (PUPA) 63-128302 discloses a method in which coloured pixels are formed by the printing method, and then pinhole defects are repaired, and a black matrix is formed, by exposing a black negative type photosensitive resin applied to the coloured pixels from the transparent substrate side, the coloured pixels being used as the photo mask.

The paper by T. Fukuchi, M. Suginoya, H. Kawamori, and K. Iwasa titled "Self-Alignment Fabrication of ITO Electrode Pattern on Electrodeposited Tricolor Filter in Black Matrix: An Application to STN-LCD" published on pages 388 to 391 of "JAPAN DISPLAY ′89", issued October 16, 1989, discloses the formation of a black matrix between coloured pixels formed by electrodeposition. The method involves applying a black negative type photosensitive resin to the whole surface of the transparent substrate side (after forming coloured pixels by electrodeposition), and then exposing this resin using the coloured pixels as the photo mask.

According to the method of PUPA 63-128302, the black matrix portion and pinhole defective portions of the coloured pixels will become the same optical density, since the black matrix and the pinhole defects of the coloured pixels are composed of and filled with the black resin of the same material with the same film thickness. Since the black matrix requires an optical density of at least 2.0 (log 1/T, where T is the transmittance) for light shielding, the pinhole defects may be perceived as black defects especially when a static picture is displayed.

The paper of Fukuchi et al. (JAPAN DISPLAY, 1989) proposes only a method of providing a black matrix in self alignment but never suggests how to repair colour filter defects. If pinhole defects caused by the photolithographic process or the electrodeposit filter forming process are present, the pinhole defects will be filled with a black resin having the same optical density as the black matrix and can be perceived as a black defect, particularly when a static picture is displayed, as in the case of PUPA 63-128302. Therefore, the method of repairing the defective portion and forming black matrix using the same material at the same time merely results in changing white defects into black defects, which are, after all, perceived a defects when displayed; thus, this cannot be said to be a true repair.

It is a primary object of the invention to provide a simple method of correcting defects in a colour filter containing coloured pixels so that the defects produced in the filter are not perceived as defects in normal use when characters or graphics are displayed through the colour filter.

A second object of the invention is to provide a simple method of repairing a colour filter so that even a defect extending over a plurality of coloured pixels is not perceived as a defect in normal use when characters or graphics are displayed through the filter.

Viewed from a first aspect, the present invention provides a method of correcting defects in a colour filter containing coloured pixels, the coloured pixels being formed of a negative type photosensitive resin containing a pigment, said defect or defects affecting pixels of only one particular colour, the method comprising the steps of: applying a negative type photosensitive repair resin, in which a pigment of the same colour as said coloured pixels having the defect is dispersed, to said coloured pixels having the defect; exposing said applied repair resin to light through said coloured pixels having the defect, the light having a wavelength which the repair resin is reactive to, but at which the transmittance of the coloured pixels is low, hence causing the repair resin only to react in the defective region; and developing said exposed repair resin, whereby only the reacted portion of the repair resin remains.

Viewed from a second aspect, the present invention provides a method of correcting defects in a colour filter containing coloured pixels, the coloured pixels being formed of a negative type photosensitive resin containing a pigment, each said defect extending over a plurality of differently coloured pixels, the method comprising the steps of: applying a negative type photosensitive repair resin coloured grey with a pigment to the plurality of coloured pixels with said defect; exposing said applied repair resin to light through said plurality of coloured pixels with the defect, the light having a wavelength which the repair resin is reactive to, but at which the transmittance of the coloured pixels is low, hence causing the repair resin only to react in the defective region; and developing said exposed repair resin, whereby only the reacted portion of the repair resin remains.

Colour filters which have had defective pixels repaired by the method of the present invention can be used in the same way as filters with no defects. In preferred embodiments the corrected colour filters can be incorporated in a liquid crystal display device having a liquid crystal material layer interposed between a pair of transparent substrates.

The present invention will be described further, by way of example only, with reference to an embodiment thereof as illustrated in the accompanying drawings, in which:
Figure 1 is a sectional view showing three steps during the correcting method according to the preferred embodiment of the present invention;
Figure 2 is a plan view showing a colour filter having a defect in its colour pixels, for which the correcting method shown in Figure 1 is intended;
Figure 3 shows a cross-section along line A-A of Figure 2;
Figure 4 is a spectrum diagram showing the emission spectrum of the light source used in the light exposure process of the correcting method shown in Figure 1;
Figure 5 is a spectrum diagram showing the spectral transmission spectrum of the color filter's red, green, and blue pixels with defects working as a photomask in the light exposure process of the correcting method shown in Figure 1;
Figure 6 is a graph showing the spectral sensitivity of the negative type photosensitive resin, containing pigment, used as a repairing material;
Figure 7 is a plan view showing colour filter having a defect extending over a plurality of coloured pixels of different colours;
Figure 8 shows a section along line B-B of Figure 7;
Figure 9 is a sectional view showing three steps of a preferred method of correcting a defect extending over coloured pixels of different colours; and
Figure 10 is a sectional view showing an example of a liquid crystal display device incorporating a colour filter corrected by the method of the preferred embodiment shown in Figure 1.

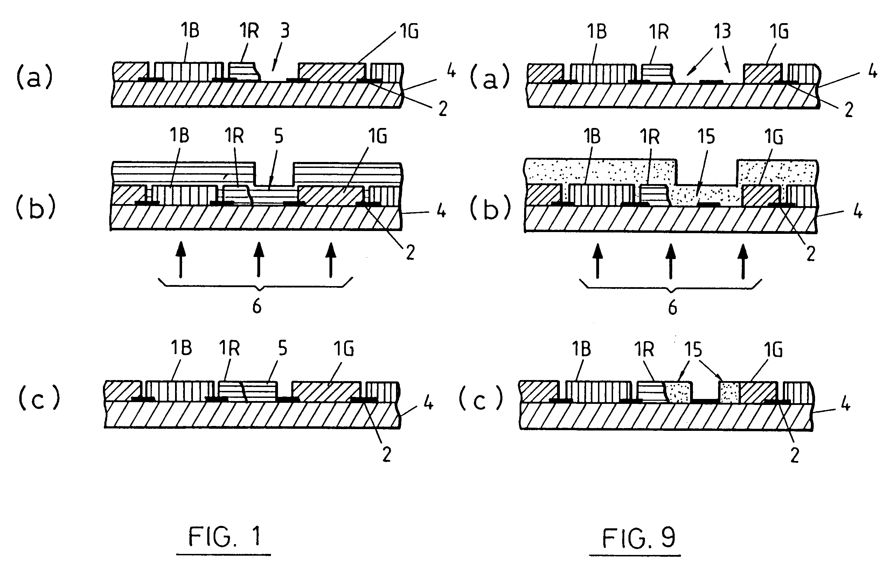

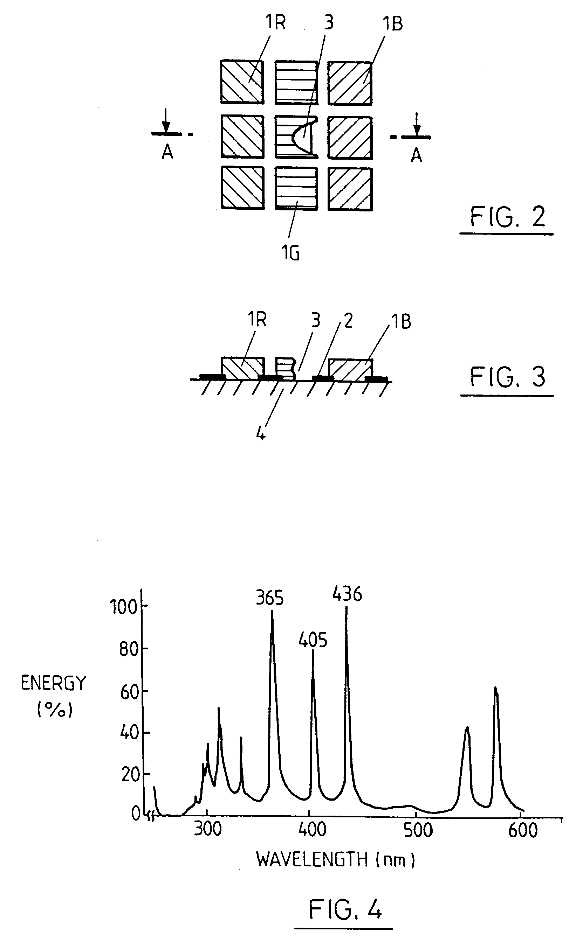

Figure 1 shows each step of the process of correcting a colour filter according to the preferred embodiment of the invention. Figures 2 and 3 show a colour filter with a defect to which the correcting process shown in Figure 1 is applied. In Figures 2 and 3, red pixels 1R, green pixels 1G, and blue pixels 1B are arranged on a transparent substrate 4 comprised of glass. The red, green, and blue pixels 1R, 1G and 1B are composed of a negative type photosensitive resin containing pigments of the corresponding colours respectively. Hereinafter the term "coloured pixel" will be used as a general term representing the red, green, and blue pixels inclusively. Between the coloured pixels, a black matrix 2 is provided for light shielding. The black matrix 2 can be formed of a metal such as chromium, or an organic film with a black coloured material (pigment, dye) dispersed therein.

If there is a defect 3, such as a pinhole or a break, in a coloured pixel, light generated from a back light source directly leaks through defect 3 and produces an area of different brightness to the coloured pixel portion. This is easily perceived particularly when a static picture is displayed. In the preferred embodiment the defective portion is corrected by filling it with a negative type photosensitive resin containing a pigment of the same colour as the materiel forming the coloured pixel.

When irradiated with light from the substrate 4 side, the intensity and spectrum of light transmitted through the defective portion 3 is naturally different from the intensity and spectrum of light transmitted through the portion of properly formed colour filter. At the defective portion 3, since the light is transmitted only through the glass substrate 4, the intensity and spectrum of light is not significantly changed, while in the portions formed of coloured pixels 1R, 1G, and 1B, the light is attenuated by the amount of the light absorbed by the coloured pixels, and therefore the intensity and spectrum are largely different to those of the light passing through the defective portion 3.

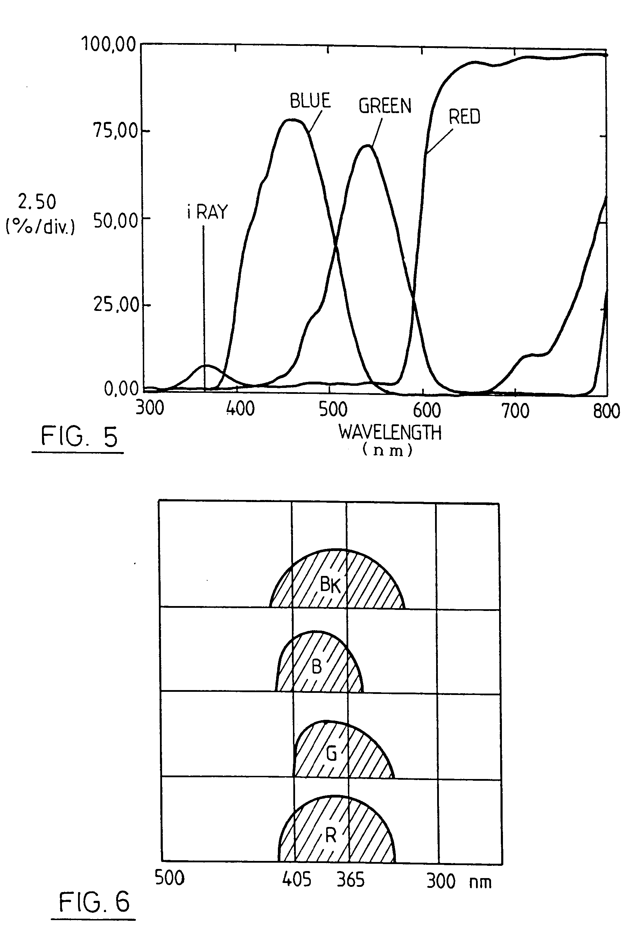

Figure 4 shows an emission spectrum of the extra-high voltage mercury-vapor lamp used in the correcting process, Figure 5 shows a spectral transmission spectrum of properly formed red, green, and blue coloured pixels used as a photomask, and Figure 6 shows the relative spectral sensitivity of the negative type photosensitive repair resin with pigment dispersed therein. In Figure 6, B_{K}, B, G, and R represent the relative spectral sensitivities of negative type photosensitive resins containing black, blue, green and red pigments respectively. It is understood from Figure 6 that the negative type photosensitive repair resin with pigment dispersed therein mainly reacts to light of i-line (365 nm) during the formation of patterns, and from Figure 5 that the transmittance at 365 nm is 7.6% for red pixels, 0.89% for green pixels, and 0.01% for blue pixels. Therefore, when applying the negative type photosensitive repair resin 5 with pigment dispersed therein on the pixels as shown in Figure 1 (a), and irradiating it with light 6 from the transparent substrate 4 side, through the coloured pixels 1B, 1R, and 1G, as shown in Figure 1 (b), then at the defective portion 3 the negative type photosensitive repair resin reacts and polymerizes. However, the negative type photosensitive repair resin on the coloured pixels 1B, 1R, and 1G does not react, because of the masking effect of the coloured pixels, and is removed when developed. Accordingly, the defective portion is filled up with the repairing material 5 in self alignment as shown in Figure 1 (c).

A negative type photosensitive resin that satisfies the above conditions is for example a photosensitive resin of radical polymerization type in which pigments of various colours in submicron particle diameters are dispersed, as described in PUPA 1-152449. This photosensitive resin comprises a polyfunctional acrylic ester monomer, a trihalomethyl triazine type photopolymerization initiator, and an acrylic acid/acrylic ester copolymer.

The colour pigments of submicron particle diameter are of the same composition as each type of coloured pixel already formed. Specifically, the red pigment comprises at least one of an anthraquinone type pigment and a perylene type pigment, mixed with an isoindoline type yellow pigment or a disazo type yellow pigment. The green pigment comprises a halogenated phthalocyanine type pigment mixed with a disazo type yellow pigment or an isoindoline type yellow pigment, and the blue pigment comprises a phthalocyanine type pigment mixed with a dioxazine type violet pigment.

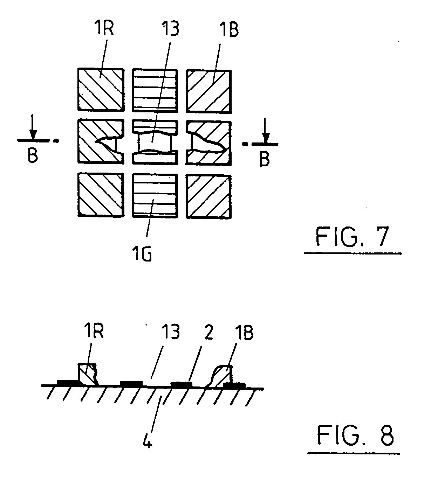

Figures 7 and 8 show a color filter having a defect extending over a plurality of differently coloured pixels. The presence of a defective portion 13 extending over differently coloured adjacent pixels is easily perceived as a defect because the brightness of the defective portion 13 is different from that of the portion formed of coloured pixels, leading to remarkably decreased display quality. If filled up with a black material having the same optical density as the black matrix, as disclosed in PUPA 63-128302, such a defective portion is perceived as a black defect. Further, it may actually be impossible to achieve repair with a negative type photosensitive resin containing a pigment of each of the various specified colours by one irradiation from the transparent substrate side, since the minute portions must be separately coated with a specified thickness. It may be possible by alignment using photomasks, but there may be little advantage in this, since the same number of photo processes as the number of defective colours would be required.

Not limited only to the cases of 8-colour display in the structure of red, green, and blue and gradation display, the higher the resolution, the more distinct the defect becomes, since the difference in luminance from the surrounding pixels becomes greater and human eyes are more sensitive to brightness than to colour itself. A pixel with an appropriately coloured pixel collection displays red, green, blue, or medium tones of each, and black, but the defective portion displays only white or black. In either case, the brightness from the defective portion is higher than that from the portions in which coloured pixels are formed, and it is necessary to decrease transmittance by a repairing material. When the brightness is reduced the defect becomes more difficult to perceive. The defect also becomes harder to see when a material of an achromatic colour or grey colour is used, the colour temperature of this material being equal to the colour temperature of white obtained according to the additive process from the lights coming out through the appropriately formed pixels of red, green, and blue. An achromatic colour material is perceived as a black defect in a white display when its transmittance is 30% or less, and looks white in a colour display when its transmittance is 60% or more. When the opening ratio is about 50%, the optimum transmittance is 30-60%.

A suitable negative type photosensitive resin for filling the defective portion 13 extending over a plurality of adjacent differently coloured pixels is a radical polymerization type photosensitive resin, described in PUPA 1-152449, comprising a polyfunctional acrylic ester monomer, a trihalomethyl-triazine type photopolymerization initiator, and a copolymer of acrylic acid/acrylic ester.

The photosensitive resin has submicron particles of achromatic colour pigment dispersed in it. Suitable achromatic colour pigments include at least one of either carbon black or titanium carbon and, if required, a pigment for adjusting the colour temperature is also added. The pigment for adjusting colour temperature is finely dispersed in submicron particle size like the achromatic colour pigment. Red, green, blue, yellow, and purple pigments are used as required.

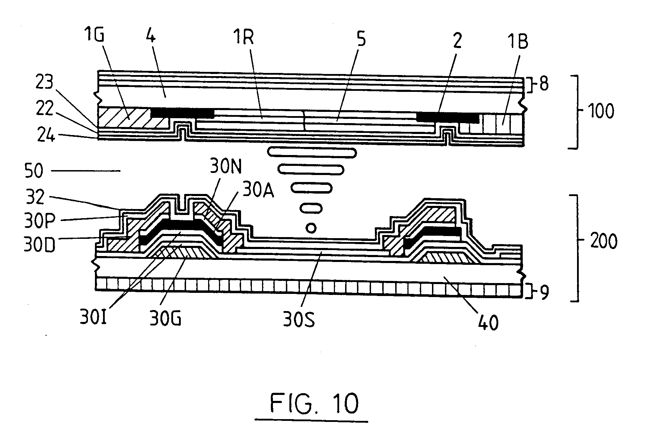

Figure 9 shows each step of the process of correcting a defect extending over differently coloured pixels according to a preferred embodiment. Figure 9 (a) represents a colour filter having a defective portion 13 extending over adjacent red pixel 1R and green pixel 1G. As shown in Figure 9 (b), a negative type photosensitive resin 15 coloured grey or an achromatic colour with a pigment is applied on the coloured pixels 1B, 1R, and 1G, and then exposed to light from the transparent substrate side through the coloured pixels 1B, 1R, and 1G. (Here, these coloured pixels work as photomasks.) Thereafter, the photosensitive resin 15 is developed. Then, only the negative type photosensitive resin 15 that has received light through the defective portion 13 remains, as shown in Figure 9 (c). The black matrix 2 has a light shielding function, and hence works as a photomask. Thus, the negative type photosensitive resin is not left on this part.

There now follows a discussion of two specific implementations of the above described preferred embodiment:

### Example 1

On a transparent substrate 4 with a black matrix 2 formed thereon by use of chromium, were applied successively COLOR MOSAIC CRY, CGY, and CBV made by Fuji-Hant Electronics Technology, Ltd. which are red, green, and blue pigments dispersed, respectively, in a negative type photosensitive resin. Then the MOSAIC were exposed, developed, and post-baked to form a colour filter. To repair a defect 3 in a red pixel 1R of the colour filter, CRY was spin-coated thereon, exposed to an extra-high tension mercury-arc lamp light from the transparent substrate 4 side through the coloured pixels, and developed with a specified developing solution. The light exposure energy was set at 5 mJ/cm², since exposure with energy exceeding 5 mJ/cm² polymerized the photosensitive repair resin, even on the correctly formed red pixel 1R. Under this condition, only the photosensitive resin in the defective portion was polymerized, and the defective portion 3 could hence be filled with repairing material 5. To produce a liquid crystal cell, an ITO transparent electrode was formed by spatter on the colour filter, and the colour filter with the ITO electrode was combined with a TFT substrate. When displaying was conducted using this liquid crystal cell, the defective portion could not be identified.

### Example 2

On a transparent substrate 4 with black matrix 2 formed thereon by use of chromium, COLOR MOSIAC CRY, CGY, and CBV made by Fuji-Hant Electronics Technology, Ltd. were applied successively to form a colour filter by light exposure, developing, and post-baking processes. To repair a defect produced at this time, which extended over three adjacent pixels coloured red, green, and blue respectively, black pigment (carbon black), blue pigment (phthalocyanine blue), and purple pigment (quinacridone red) were mixed together, dispersed in the negative type photosensitive resin solution, and applied to the filter. These pigments were added such that the transmittance became 40% when the film thickness was the same as that of the coloured pixels, and the colour temperature (9000 K) was equal to the white colour resulting from the additive colour mixing of red, green, and blue. By exposing the resin to light of 5 mJ/cm² energy from the extra-high tension mercury-arc lamp from the transparent substrate 4 side through the coloured pixels, and by developing, only the defective portion 13 was filled up. A liquid crystal cell was formed by combining the corrected filter with an ITO transparent electrode and a TFT substrate, and displaying was conducted using this liquid crystal cell. During displaying the defect, which would look like a twinkling star if the repair had not been made, could hardly be perceived.

Figure 10 shows an example of a liquid crystal display incorporating the colour filter corrected by the method shown in Figure 1. Between a colour filter substrate 100 and a TFT substrate 200, a nematic liquid crystal material layer 50 is inserted. The colour filter substrate 100 comprises, in addition to the transparent glass substrate 4 shown in Figure 1: a polarizing plate 8;
red, green, and blue pixels 1R, 1G, and 1B;
a black matrix 2;
a negative type photosensitive resin 5 containing red pigment filled in the defective portion;
a top coat layer 23;
an ITO common electrode 22 formed on the whole surface; and
a liquid crystal orientation film 24 comprising, for example, polyimide, formed on the electrode 22.

The TFT substrate 200 comprises a transparent glass substrate 40, a polarizing plate 9, a gate electrode 30G, a gate insulation film 30I, a-Si30A, n⁺a-Si30N, an ITO pixel electrode 30S, a source drain electrode 30D, a passivation layer 30P, and a liquid crystal orientation film 32.

In Figure 10, an ITO electrode is provided on the colour filter but, as in PUPA 63-298304, a colour filter may be provided on the ITO electrode.

It will be obvious to one skilled in the art that it is possible to incorporate the colour filter corrected by the method shown in Figure 9 in a liquid crystal display like that shown in Figure 10.

The repairing method of the preferred embodiment can remarkably improve display quality when defects are produced in the colour filter preparing process. Further, in accordance with the preferred embodiment, a desired portion can be corrected simply, because the repair is done by self-alignment using the colour filter as a photomask.

## Claims

1. A method of correcting defects (3) in a colour filter containing coloured pixels (1B, 1R, 1G), the coloured pixels being formed of a negative type photosensitive resin containing a pigment, said defect or defects affecting pixels of only one particular colour, the method comprising the steps of:
applying a negative type photosensitive repair resin (5), in which a pigment of the same colour as said coloured pixels having the defect is dispersed, to said coloured pixels (1B, 1R, 1G) having the defect (3);
exposing said applied repair resin (5) to light (6) through said coloured pixels (1B, 1R, 1G) having the defect (3), the light (6) having a wavelength which the repair resin is reactive to, but at which the transmittance of the coloured pixels is low, hence causing the repair resin only to react in the defective region (3); and
developing said exposed repair resin, whereby only the reacted portion of the repair resin remains.

2. A method of correcting defects (13) in a colour filter containing coloured pixels (1B, 1R, 1G), the coloured pixels being formed of a negative type photosensitive resin containing a pigment, each said defect extending over a plurality of differently coloured pixels, the method comprising the steps of:
applying a negative type photosensitive repair resin (15) coloured grey with a pigment to the plurality of coloured pixels (1B, 1R, 1G) with said defect (13);
exposing said applied repair resin (15) to light (6) through said plurality of coloured pixels (1B, 1R, 1G) with the defect (13), the light having a wavelength which the repair resin is reactive to, but at which the transmittance of the coloured pixels is low, hence causing the repair resin only to react in the defective region (13); and
developing said exposed repair resin, whereby only the reacted portion of the repair resin remains.

3. A method as claimed in Claim 2, wherein said pigment includes at least one of either carbon black or titanium carbon.

4. A method as claimed in Claim 1, wherein said pigment comprises either:
(a) at least one of an anthraquinone type pigment and a perylene type pigment, mixed with an isoindoline type yellow pigment or a disazo type yellow pigment; or
(b) a halogenated phthalocyanine type pigment mixed with a disazo type yellow pigment or an isoindoline type yellow pigment; or
(c) a phthalocyanine type pigment mixed with a dioxazine type violet pigment;
the pigments in (a) being combined to produce a red pigment, the pigments in (b) being combined to produce a green pigment, and the pigments in (c) being combined to produce a blue pigment.

5. A method as claimed in any preceding claim, wherein said negative type photosensitive repair resin (5; 15) is of radical polymerization type.

6. A liquid crystal display device having a liquid crystal material layer (50) interposed between a pair of transparent substrates (100, 200), and a colour filter containing coloured pixels (1G, 1R, 1B), defective pixels in said filter having been repaired by a method as claimed in any of Claims 2, 3 or 5, such that the defective regions (13) are filled with a grey coloured negative type photosensitive resin.

## Patentansprüche

1. Verfahren zum Korrigieren von Fehlern (3) in einem Farbfilter, der farbige Pixel (1B, 1R, 1G) enthält, wobei die farbigen Pixel aus einem lichtempfindlichen Negativharz gebildet werden, das ein Pigment enthält, wobei der Fehler oder die Fehler nur Pixel einer bestimmten Farbe betrifft bzw. betreffen und wobei das Verfahren die Schritte umfaßt:
zum Auftragen eines lichtempfindlichen, negativen Reparaturharzes (5), in dem ein Pigment verteilt ist, das dieselbe Farbe hat, wie die farbigen Pixel mit dem Fehler, auf die farbigen Pixel (1B, 1R, 1G), die den Fehler (3) aufweisen;
zum Belichten des aufgetragenen Reparaturharzes (5) mit Licht (6) durch die farbigen Pixel (1B, 1R, 1G), die den Fehler (3) aufweisen, wobei das Licht (6) eine Wellenlänge hat, bei der das Reparaturharz reagiert, bei der der Lichtdurchlaßgrad der farbigen Pixel jedoch niedrig ist, so daß das Reparaturharz nur im fehlerhaften Bereich (3) reagiert; und
zum Entwickeln des belichteten Reparaturharzes, wodurch nur der Bereich des Reparaturharzes übrigbleibt, der reagierte.

2. Verfahren zum Korrigieren von Fehlern (13) in einem Farbfilter mit farbigen Pixeln (1B, 1R, 1G), wobei die farbigen Pixel aus einem lichtempfindlichen Negativharz gebildet werden, das ein Pigment enthält, wobei sich jeder Fehler über mehrere Pixel unterschiedlicher Farbe erstreckt und wobei das Verfahren die Schritte umfaßt:
zum Auftragen eines lichtempfindlichen, negativen Reparaturharzes (15), das mit einem Pigment grau gefärbt ist, auf die Vielzahl der farbigen Pixel (1B, 1R, 1G), die den Fehler (13) aufweisen;
zum Belichten des aufgetragenen Reparaturharzes (15) mit Licht (6) durch die Vielzahl der farbigen Pixel (1B, 1R, 1G), die den Fehler (13) aufweisen, wobei das Licht eine Wellenlänge hat, bei der das Reparaturharz reagiert, bei der der Lichtdurchlaßgrad der farbigen Pixel jedoch niedrig ist, so daß das Reparaturharz nur im fehlerhaften Bereich (13) reagiert; und
zum Entwickeln des belichteten Reparaturharzes, wodurch nur der Bereich des Reparaturharzes übrigbleibt, der reagierte.

3. Verfahren nach Anspruch 2, in dem das Pigment mindestens entweder Ruß oder Titankarbon enthält.

4. Verfahren nach Anspruch 1, in dem das Pigment eines von folgendem umfaßt:
(a) mindestens ein Pigment des Typs Anthrachinon und des Typs Perylen, vermischt mit einem gelben Pigment des Typs Isoindolin oder einem gelben Pigment des Typs Disazo; oder
(b) ein halogeniertes Pigment des Typs Phthalocyanin mit einem gelben Pigment des Typs Disazo oder einem gelben Pigment des Typs Isoindolin; oder
(c) einem Pigment des Typs Phthalocyanin, gemischt mit einem violetten Pigment des Typs Dioxazin;
wobei die Pigmente in (a) kombiniert werden, um ein rotes Pigment zu bilden, die Pigmente in (b) kombiniert werden, um ein grünes Pigment zu bilden und die Pigmente in (c) kombiniert werden, um ein blaues Pigment zu bilden.

5. Verfahren nach einem der vorangehenden Ansprüche, in dem das lichtempfindliche, negative Reparaturharz (5; 15) ein Harz vom Typ der radikalischen Polymerisation ist.

6. Flüssigkristall-Anzeigegerät mit einer Flüssigkristallschicht (50), die zwischen einem Paar transparenter Substrate (100, 200) angeordnet ist, und einem Farbfilter, der farbige Pixel (1G, 1R, 1B) enthält, wobei fehlerhafte Pixel in dem Filter mit einem Verfahren nach einem der Ansprüche 2, 3 oder 5 repariert wurden, so daß die fehlerhaften Bereiche (13) mit einem lichtempfindlichen Negativharz von grauer Farbe gefüllt sind.

## Revendications

1. Procédé de correction de défauts (3) dans un filtre coloré contenant des pixels colorés (1B, 1R, 1G), les pixels colorés étant constitués d'une résine photosensible de type négatif contenant un pigment, ledit défaut ou lesdits défauts affectant des pixels seulement d'une couleur particulière, le procédé comprenant les étapes d' :
application d'une résine de réparation (5) photosensible de type négatif, dans laquelle un pigment de la même couleur que celui des pixels colorés présentant les défauts est dispersé, sur lesdits pixels colorés (1B, 1R, 1G) présentant le défaut (3);
exposition à la lumière (6) de ladite résine de réparation (5) appliquée, sur lesdits pixels (1B, 1R, 1G) présentant le défaut (3), la lumière (6) ayant une longueur d'onde à laquelle réagit la résine de réparation mais à laquelle la transmittance des pixels colorés est faible, provoquant par conséquent une réaction par la résine colorée seulement dans la zone (3) défectueuse; et
développement de ladite résine de réparation exposée, de manière à ce que seule la partie ayant réagi de la résine de réparation subsiste.

2. Procédé de correction de défauts (13) dans un filtre coloré contenant des pixels colorés (1B, 1R, 1G), les pixels colorés étant formés d'une résine photosensible de type négatif contenant un pigment, chaque dit défaut s'étendant sur une pluralité de pixels de couleur différente, le procédé comprenant les étapes d' :
application d'une résine de réparation (15) photosensible de type négatif, de couleur gris avec un pigment sur la pluralité de pixels colorés (1B, 1R, 1G) présentant ledit défaut (13);
exposition à la lumière (6) de ladite résine de réparation (15) y ayant été appliquée, sur ladite pluralité de pixels colorés (1B, 1R, 1G) présentant le défaut (13), la lumière ayant une longueur d'onde à laquelle la résine de réparation réagit mais à laquelle la transmittance des pixels colorés est faible, provoquant par conséquent une réaction de la résine de réparation seulement dans la zone (13) défectueuse; et
développement de ladite résine de réparation exposée, de manière que seule la partie ayant réagi de la résine de réparation subsiste.

3. Procédé selon la revendication 2, dans lequel ledit pigment comprend au moins soit du noir de carbone, soit du carbure de titane.

4. Procédé selon la revendication 1, dans lequel ledit pigment comprend soit :
(a) au moins un pigment parmi un pigment de type anthraquinone et un pigment de type pérylène, mélangé avec un pigment jaune de type isoindoline ou un pigment jaune de type disazo; ou
(b) un pigment de type phthalocyanine halogéné, mélangé avec un pigment jaune de type disazo ou un pigment jaune de type isoindoline; ou
(c) un pigment de type phthalocyanine, mélangé avec un pigment violet de type dioxazine;
les pigments indiqués dans (a) étant combinés pour produire un pigment rouge, les pigments indiqués dans (b) étant combinés pour produire un pigment vert; et les pigments indiqués dans (c) étant combinés pour produire un pigment bleu.

5. Procédé selon l'une quelconque des revendications précédentes, dans lequel ladite résine de réparation (5; 15) photosensible de type négatif est de type à polymérisation de radicaux.

6. Dispositif d'affichage à cristal liquide présentant une couche de matériau cristallin liquide (50), interposé entre une paire de substrats transparents (100, 200) et un filtre coloré contenant des pixels colorés (1G, 1R, 1B), les pixels défectueux se trouvant dans ledit filtre ayant été réparé par le procédé selon l'une quelconque des revendications 2, 3 ou 5, de manière que les zones (13) défectueuses soient comblées d'une résine photosensible, de type négatif, de couleur grise.
